# FASCICULE DE BREVET EUROPEEN

(11) **EP 3 659 273 B1**
(45) Date de publication et mention de la délivrance du brevet: **11.09.2024**
(21) Numéro de dépôt: 18765484.3
(22) Date de dépôt: 26.07.2018
(51) Int. Cl.: H04B 7/185, H04W 52/28

(54) **SYSTÈME DE FOURNITURE NOTAMMENT D'INTERNET SUR TOUTE LA SURFACE DU GLOBE TERRESTRE, CHARGE UTILE ET AVION**
SYSTEM ZUR BEREITSTELLUNG INSBESONDERE VON INTERNET ÜBER DIE GESAMTE OBERFLÄCHE DER ERDKUGEL, NUTZLAST UND FLUGZEUG
SYSTEM FOR THE PROVISION IN PARTICULAR OF INTERNET OVER THE ENTIRE SURFACE OF THE TERRESTRIAL GLOBE, PAYLOAD AND AIRCRAFT

(30) Priorité: 27.07.2017 FR 1757121; 27.07.2017 US 201762537559 P
(43) Date de publication de la demande: 03.06.2020
(73) Titulaire: Prodose, 31660 Bessieres (FR); Boukari, Morou, 31400 Toulouse (FR)
(72) Inventeur: BOUKARI, Morou, 31400 Toulouse (FR)
(74) Mandataire: Leone, Eloïse
(86) Numéro de dépôt international: PCT/FR2018/051930
(87) Numéro de publication internationale: WO 2019/020956

(56) Documents cités:
- US-A1- 2005 108 374
- US-A1- 2010 311 460
- US-A1- 2014 333 491
- US-A1- 2016 046 387
- US-B1- 6 285 878

## Description

### DOMAINE D'APPLICATION DE L'INVENTION

La présente invention a trait au domaine de la mise en oeuvre de réseau de type internet et notamment aux adaptations permettant de proposer ce service sur la totalité de la surface terrestre dans les meilleures conditions.

### DESCRIPTION DE L'ART ANTÉRIEUR

En France, le signal télévisé est diffusé en numérique sous la norme DVB (Digital Video Broadcasting) qui définit la méthode de transmission des services télévisés (signal vidéo, signal audio et données telles que le télétexte par exemple). Cette norme est adaptée et déclinée pour chaque mode de diffusion.

Afin de fournir internet à la surface du globe terrestre par une communication sans fil, il existe une pluralité de solutions de liaison sans fil numérique utilisant des signaux de données numériques.

Il est par exemple connu des constellations et des projets de constellations de satellites artificiels pour la fourniture d'internet à la surface du globe terrestre et pour la transmission air-sol/sol-air de données numériques.

Ces satellites sont classiquement équipés :
- d'une plateforme qui assure la fonction d'alimentation électrique du satellite, de propulsion et de maintien en altitude,
- d'une charge utile comprenant un ou plusieurs répétiteurs composés des éléments suivants:
   - une ou plusieurs antennes de réception de données sol-air issues d'une ou plusieurs stations terrestres,
   - un ou plusieurs modules d'amplification et de polarisation des signaux reçus depuis la terre,
   - une ou plusieurs antennes d'émissions air-sol des signaux amplifiés vers le sol.

Ces satellites artificiels présentent néanmoins plusieurs inconvénients décrits ci-après.

Ils produisent beaucoup de débris dans l'espace autour de la terre (plus de vingt mille débris actuels) et sur cinq mille satellites lancés depuis 1957, seulement mille quatre cents sont opérationnels en 2016, le reste est non-opérationnel et encombre l'espace.

Ils présentent une puissance limitée. En effet, la puissance maximale actuelle du plus gros satellite est de vingt-deux kilowatts.

Ils sont dédiés à leur seule fonction.

Leurs coûts de fabrication et de lancement sont très élevés.

Il n'est pas possible de les réparer ou de changer des pièces défectueuses une fois lancés dans l'espace et une fois tournant sur leur orbite.

Ils circulent à une altitude et sur des orbites fixes autour de la terre.

La charge utile présente un poids très limité compte tenu des limites techniques des dispositifs de lancement et des coûts de lancement (le poids actuel maximal est de huit tonnes avec une charge utile inférieure à cinq tonnes). Ainsi, par exemple, le nombre maximal actuel de répétiteurs pour le plus gros satellite est inférieur à soixante-dix.

Le débit de transmission air-sol des données est faible.

Pour éviter la perte de gain de réception au sol et compte tenu du fait que ces satellites circulent à plus de cent kilomètres autour de la terre, l'angle d'ouverture des antennes d'émission air-sol est très faible (inférieur à quatre vingt dix degrés),

La protection des charges utiles et des plateformes des satellites requiert le recours à des matériaux nobles compte tenu de l'environnement très agressif dans lequel évoluent ces satellites.

Il existe aussi des projets de fourniture air-sol d'internet au moyen de ballons remplis d'hélium ou d'avions sans pilote solaires volant dans la stratosphère (entre quatorze et vingt kilomètres) mais ces projets présentent beaucoup d'inconvénients des constellations de satellites avec par exemple :
- un coût inférieur mais non négligeable,
- une fonction dédiée,
- une zone de couverture restreinte (inférieure à cent kilomètres au sol) et une très faible puissance d'émission (inférieure à un kilowatt).

Le document US 6285878 décrit une nouvelle utilisation pour les flottes (déjà existantes) d'avions commerciaux pour remplacer les satellites de communication en orbite terrestre basse (LEO). Ce document décrit une infrastructure de communication sans fil à large bande peu coûteuse point-à-point réalisée en utilisant et en modifiant de petits équipements de station de micro-ondes à faible puissance, légers et à faible coût existants à bord des avions commerciaux. Chaque aéronef équipé disposerait d'une liaison de communication sans fil à large bande (à l'intérieur de leur plage de portée) vers un ou plusieurs aéronefs ou stations terrestres voisins et constituerait une chaîne continue de répéteurs aériens fournissant des passerelles de communication sans fil à large bande sur toute la trajectoire. Les services de communication sans fil à large bande sont également fournis aux clients à bord d'un vol ainsi qu'aux clients en dehors, le long des trajectoires de vol de l'avion commercial.

Un tel système propose une solution de communication alternative aux réseaux de satellites mais présente également des inconvénients, parmi ceux-ci :
- il ne modère pas les puissances des communications en fonction de l'altitude des avions,
- il ne gère pas les communications en phase de décollage et de montée à l'altitude de croisière ni de phase de descente jusqu'à l'atterrissage,
- il ne résout pas les problèmes techniques liés à la propagation d'ondes à proximité des passagers ou des utilisateurs.

Le document US2005/108374 décrit un système de relais radioélectriques aéroportés comprenant une station de contrôle de réseau, au moins une station au sol, des stations relais de contrôleurs de grappes aéroportées et une ou plusieurs stations non aériennes, qui peuvent être mobiles. La station de contrôle du réseau accède à une base de données fournissant des informations de position quadridimensionnelle en temps réel concernant les stations aériennes de l'espace aérien national et international. Elle désigne et redésigne de manière dynamique certaines stations aéroportées afin de leur permettre de répéter le trafic en réponse aux changements de la structure du trafic aérien afin que les anneaux concentriques des stations relais qui se chevauchent soient maintenues. Les stations émettrices utilisent des techniques de duplexage par répartition dans le temps pour transférer le trafic, qui comprend le trafic de communications de données à commutation de paquets. Néanmoins, ce document ne cherche pas à solutionner le problème lié à l'exposition des êtres vivants aux ondes ou aux rayonnements des signaux des communications. Il ne fournit pas non plus une robustesse dans les communications en réduisant les interférences causées par l'aéronef aux systèmes terrestres tout en fournissant aux utilisateurs au sol ou aux passagers des signaux numériques dans les meilleures conditions possibles.

### DESCRIPTION DE L'INVENTION

Partant de cet état de fait, les demandeurs ont mené des recherches visant à proposer une alternative au déploiement de satellites ou d'aéronefs supplémentaires dédiés à la création d'un réseau sans fil de données de type internet et/ou de télévision.

Ces recherches ont abouti à la conception et à la réalisation d'un système pour la fourniture de signaux de données numériques de type internet et/ou télévision sur toute la surface du globe terrestre, laquelle surface accueille au moins une station terrestre d'émission et de réception de signaux de données numériques de type internet et/ou télévision. Ledit système relie par liaison sans fil numérique au moins un aéronef avec la station terrestre d'émission et de réception de signaux de données de type internet et/ou télévision d'une part et d'autre part avec au moins un moyen d'émission et de réception de signaux de données de type internet et/ou télévision individuels ou collectifs fixe ou porté par au moins un utilisateur, ledit aéronef évoluant à une altitude inférieure ou égale à dix kilomètres au-dessus de la surface du globe terrestre, et étant équipé d'une ou plusieurs charges utiles (telle que définie dans la description de l'art antérieur) de telle façon à servir de relais d'émission et de réception pour la fourniture d'au moins un type de signaux sur la surface du globe terrestre.

Selon l'invention, le système est remarquable en ce que la puissance des signaux (rayonnements) émis par la charge utile est modulée pour varier en fonction de l'altitude de l' aéronef et peut donc varier de 0% au sol à 100% en vol de croisière.

L'aéronef peut être un avion, un drone, un ballon, etc... dont le vol de croisière ne dépasse pas les 10 kilomètres d'altitude.

Cette caractéristique est particulièrement avantageuse en ce que :
- le procédé fait varier les puissances des communications en fonction de l'altitude des aéronefs,
- il gère les communications en phase de décollage et de montée à l'altitude de croisière et en phase de descente jusqu'à l'atterrissage,
- il résout les problèmes techniques liés à la propagation d'ondes à proximité de passagers ou des utilisateurs.

L'invention permet d'obtenir un réseau formé par une constellation d'aéronefs représentant chacun un module d'émission et de réception dialoguant avec des stations terrestres d'émission et de réception au sol.

Il résout une pluralité de difficultés techniques nouvelles non présentes dans les réseaux actuels.

En effet, un tel procédé en proposant une modulation de la puissance d'émission en fonction de l'altitude, ne présente pas d'inconvénient en ce qui concerne l'émission et la réception au sol des signaux compte tenu du fait que l'altitude de vol des avions n'est pas fixe et que cette altitude varie pour un même avion entre zéro kilomètre (au sol) et dix kilomètres (en vol de croisière).

L'altitude est constamment mesurée sur un avion et est donc déjà une donnée à disposition pour la mise en oeuvre du procédé qui fait varier la puissance en fonction de cette altitude.

Cette modulation participe à la protection des animaux et des hommes contre les rayonnements reçus au sol et en provenance de la charge utile équipant les avions compte tenu de la très faible altitude de vol des avions (inférieure à dix kilomètres) et compte tenu de la très grande puissance d'émission éventuelle des antennes de la charge utile.

Selon une application préférée mais non limitative, l'invention consiste à faire porter à des avions de transport de passagers l'équivalent fonctionnel de la charge utile jusqu'ici portée par des satellites. Ces avions disposent d'une soute et donc de la puissance nécessaire au transport d'une telle charge utile additionnelle, ledit avion transportant des passagers et/ou un fret de plus de cinq cents kilogrammes, ledit avion transportant au moins une personne. La ou les charges utiles sont alimentées par l'énergie de l'avion. C'est-à-dire que lorsque par exemple, la ou les charges utiles utilisent l'énergie électrique, elles sont alimentées par l'énergie électrique de l'avion oubien utilisent pour leurs moteurs ou leurs actionneurs le même carburant que l'avion.

L'exploitation des avions de passagers pour fournir un réseau de communication présente de nombreux avantages.

Il existe actuellement plusieurs dizaines de milliers d'avions civils de transport de passagers qui effectuent plusieurs centaines de milliers de trajets par jour, lesquels trajets couvrent presque entièrement la surface du globe terrestre dans l'espace situé entre zéro et dix kilomètres d'altitude.

En équipant tous ces avions de charges utiles du type des charges utiles telles celles décrites plus haut équipant les satellites artificiels avec cependant des adaptations (modifications) techniques, l'invention a pour objet de bâtir une constellation d'avions qui va assurer à la fois le transport de passagers et la fourniture air-sol/sol-air des connexions internet sur toute la surface du globe terrestre et ce à moindre coût (réduction des coûts par un facteur de cent à mille) par rapport aux satellites artificiels. Un tel réseau peut se substituer ou venir en complément de ceux déjà existants.

L'invention permet donc de fournir des connexions internet sur toute la surface du globe terrestre en utilisant des avions actuels et futurs de transport de passagers et en équipant ces avions de charges utiles de type charges utiles utilisées dans les satellites artificiels moyennant des adaptations (modifications) techniques.

Bien entendu, il existe aujourd'hui des avions de transport de passagers équipés pour fournir de l'internet aux passagers (jusqu'à cinq cents passagers) en recevant des signaux à partir d'une station terrestre ou d'un satellite. Néanmoins, ce type d'avions n'est pas équipé pour fournir l'internet au sol comme le propose l'invention.

Les avions sont aussi équipés de moyens indispensables à leur navigation (anticollision, alerte, maintenance). Ce sont des moyens de réception sol-air de signaux, des moyens d'émissions air-sol de signaux et des moyens air-air des signaux. Ces moyens de navigation ne sont pas adaptés et ne sont pas destinés à fournir de l'internet (air-sol) à la surface du globe terrestre. Toutefois, ces moyens vont permettre le suivi des avions par les stations terrestres d'émission et de réception constituant le réseau.

L'invention permet d'envisager une nouvelle méthode économique en proposant une nouvelle source de rentabilité à l'exploitation des avions civils actuels et futurs.

En exploitant des avions destinés au transport de passagers et/ou du fret, l'invention évite l'encombrement et la pollution du ciel et de l'espace par des débris de satellites et des satellites en fin de vie.

L'invention permet de réduire selon un facteur allant de cent à plus de mille, les coûts de fabrication, d'exploitation des charges utiles des satellites et des systèmes de transmission air-sol et sol-air des données numériques. Par exemple, il n'est plus nécessaire de recourir à des matériaux nobles de protection des charges utiles dans les dispositifs de transmission air-sol des données numériques.

L'invention favorise ainsi l'accès à moindre coût à internet à toute la population du globe terrestre.

L'équivalent fonctionnel de la charge utile va utiliser directement l'alimentation électrique de l'avion ou son carburant. Il n'est pas nécessaire de disposer d'une plateforme à cet effet comme pour un satellite. La charge utile de l'avion va ainsi pouvoir disposer jusqu'à plus de 500 kilowatts.

De plus, l'exploitation d'avions offre la possibilité de réparer la charge utile et de changer les pièces défectueuses une fois l'avion revenu au sol. Les avions peuvent transporter une charge utile pouvant atteindre cinquante à cent tonnes équipée d'une pluralité d'antennes d'émission et d'antennes de réception. De plus, le nombre de répétiteurs est beaucoup moins limité et peut atteindre plusieurs milliers par avion.

Les débits de transmission air-sol/sol-air des données numériques sont donc augmentés. L'augmentation est également due au fait que les avions transportant les charges utiles ne vont pas au delà de dix kilomètres qui sont à comparer avec les orbites des satellites (plus de cent kilomètres). L'angle d'ouverture des antennes va pouvoir être augmenté et atteindre cent quatre-vingts degrés.

De plus, la transmission est fonctionnelle et adaptée même dans les phases de montée après décollage et de descente avant atterrissage contrairement à ce que proposait l'art antérieur.

L'invention concerne également le dispositif c'est-à-dire la charge utile.

Ladite charge utile comprend une ou plusieurs antennes d'émission des signaux de données numériques vers la surface du globe terrestre.

Selon une autre caractéristique particulièrement avantageuse de l'invention, l'antenne a un grand angle d'ouverture qui atteint 180 degrés lui permettant de couvrir une très grande surface rayonnée au sol pouvant atteindre sept cent mille kilomètres carrés.

Selon une autre caractéristique particulièrement avantageuse de l'invention, l'angle d'ouverture est variable en fonction de l'altitude grâce à un moyen de variation d'angle d'ouverture dont l'antenne est munie.

Selon une autre caractéristique particulièrement avantageuse de l'invention, le moyen de variation d'angle d'ouverture est relié à des capteurs de mesure d'altitude équipant l'aéronef et/ou la charge utile.

Selon une autre caractéristique particulièrement avantageuse de l'invention, la variation d'angle d'ouverture se fait dans le sens croissant lorsque l'altitude décroit de telle façon à permettre à l'antenne d'avoir la même surface rayonnée au sol quelle que soit l'altitude à laquelle se trouve l'aéronef.

Selon une autre caractéristique particulièrement avantageuse de l'invention, l'angle d'ouverture maximal atteint 180 degrés.

Selon une autre caractéristique particulièrement avantageuse de l'invention, la valeur maximale de l'angle d'ouverture est comprise entre 90 degrés et 180 degrés.

L' antenne comporte un variateur de puissance d'alimentation générale de l'antenne de zéro pour cent (au sol) à cent pour cent (altitude maximale) de la puissance maximale d'alimentation (puissance à l'altitude maximale), de telle façon que chaque point de la surface rayonnée au sol par l'antenne reçoive la même puissance rayonnée quelle que soit l'altitude de l'aéronef et de telle façon à pouvoir éteindre le rayonnement de l'antenne une fois l'aéronef au sol.

Laquelle antenne est composée de plusieurs cellules concentriques munies chacune d'un variateur individuel de puissance permettant d'adapter la puissance d'alimentation de chaque cellule en fonction de la position de chaque cellule par rapport à la cellule centrale de telle façon que la valeur de la puissance d'alimentation individuelle de chaque cellule augmente de la cellule centrale vers les cellules périphériques de manière à avoir la même puissance rayonnée reçue au sol quelle que soit la position du point de réception des signaux numériques dans la surface rayonnée au sol.

L'invention permet ainsi de proposer un réseau de communication efficace malgré les variations d'altitude des différents aéronefs le composant.

Selon une autre caractéristique de l'invention, la puissance maximale d'alimentation de la charge utile atteint 500 Kilowatts.

Selon une autre caractéristique de l'invention, la puissance maximale d'alimentation de la charge utile est comprise entre 2 Kilowatts et 500 Kilowatts.

Selon une autre caractéristique de l'invention, la puissance maximale d'alimentation de la charge utile est comprise entre 23 Kilowatts et 500 Kilowatts.

Selon une autre caractéristique de l'invention, la puissance maximale d'alimentation de la charge utile est comprise entre 30 Kilowatts et 500 Kilowatts.

L'invention concerne également l'avion de transport de passagers et/ou de fret qui est équipé d'au moins une charge utile.

Les caractéristiques suivantes sont des exemples qui ne font partie de l'invention,

L'avion est remarquable en ce qu'il transporte des passagers et/ou un fret de plus de cinq cents kilogramme et est équipé d'au moins une charge utile alimentée par l'énergie de l'avion destinée à la transmission et réception des signaux, et d'une pluralité d'antennes additionnelles autres que celles nécessaires à la navigation d'un avion et mises en oeuvre selon au moins une des technologies suivantes :
- antennes peintes ou imprimées sur le fuselage et/ou les ailes de l'avion et/ou des dérives,
- antennes planaires du type « patch » recouvrant tout ou partie du fuselage, et/ou des ailes, et/ou des dérives de l'avion.

Afin de protéger les passagers et les membres d'équipage contre les forts rayonnements émis par la charge utile, selon une caractéristique particulièrement avantageuse, au moins une couche de peinture absorbante des rayonnements électromagnétiques issus des signaux est appliquée sur la paroi extérieure de l'avion. Il existe dans le commerce des peintures ayant ces caractéristiques absorbantes mais il est nouveau de l'utiliser afin de protéger les passagers d'un aéronef transportant la source d'émission.

Selon une caractéristique particulièrement avantageuse, cette couche de peinture absorbante fait partie des premières appliquées.

Elle assure sa fonction de protection tout en autorisant l'utilisation d'antennes sur les couches extérieures. Elle protège l'intérieur de l'avion des émissions issues des autres avions.

Selon une autre caractéristique particulièrement avantageuse de l'invention participant également à la protection, des matériaux d'isolation phonique et thermique absorbant les rayonnements électromagnétiques sont appliqués sur la paroi intérieure de l'avion. Il existe dans le commerce des matériaux ayant ces caractéristiques absorbantes mais il est nouveau de les utiliser afin de protéger les passagers d'un aéronef transportant la source d'émission.

Selon une autre caractéristique particulièrement avantageuse de l'invention, les panneaux d'habillage intérieur de l'avion sont constitués de matériaux absorbant les rayonnements électromagnétiques.

Selon une autre caractéristique particulièrement avantageuse de l'invention, les hublots sont constitués de matériaux absorbant les rayonnements électromagnétiques.

Selon une autre caractéristique particulièrement avantageuse de l'invention, ledit avion transporte de deux à mille passagers.

Selon une autre caractéristique particulièrement avantageuse de l'invention, ledit avion transporte de cinquante à mille passagers.

L'absorption des rayonnements électromagnétiques permet également d'éviter les interférences avec les équipements de l'avion. Ainsi, lorsque l'aéronef est un avion, une autre caractéristique particulièrement avantageuse de l'invention participant à cette fonction réside dans le fait que les fréquences d'émission des charges utiles transportées par l'avion sont différentes c'est-à-dire ne sont pas les mêmes que celles des équipements de navigation.

Selon une autre caractéristique particulièrement avantageuse de l'invention où le procédé interconnecte par liaison sans fil numérique une pluralité d'avions, le procédé consiste à faire dialoguer, en les reliant par une liaison sans fil numérique, la station terrestre d'émission et de réception de signaux avec l'avion le plus haut de la pluralité d'avions avec lesquels elle communique. Cette caractéristique rationnalise les communications en disposant de l'avion assurant la couverture la plus large. Elle participe également à la protection contre les rayonnements en sélectionnant les avions mettant en oeuvre le réseau.

Selon une autre caractéristique particulièrement avantageuse de l'invention, le procédé est remarquable en ce que la station terrestre d'émission et de réception de signaux ne se connecte par liaison sans fil numérique qu'au signal le plus fort.

Pour ce faire, l'antenne de la ou des stations terrestres est équipée de moyens permettant de mesurer la puissance des signaux reçus. L'antenne se connecte selon l'invention au signal dont la valeur de puissance est la plus élevée.

Selon une autre caractéristique particulièrement avantageuse de l'invention, le procédé est remarquable en ce que lorsqu'il y a plusieurs signaux forts, la station terrestre d'émission et de réception de signaux numériques se connecte par liaison sans fil numérique à ces signaux multiples mais en utilisant comme moyens de séparation de ces signaux des moyens de mesure permettant d'identifier:
des polarisations différentes,
Des fréquences différentes,
Des visées d'azimuts pour suivre les sources.

Selon une autre caractéristique particulièrement avantageuse de l'invention, les équipements de réception au sol sont constitués d'une double antenne :
- une en fonctionnement et connectée au signal le plus fort,
- une en attente de connexion mais en recherche continue d'un signal fort.

Les caractéristiques permettent de réaliser dans les meilleures conditions une sélection parmi les signaux disponibles permettent de répondre au problème technique lié au déplacement aléatoire des avions.

Selon une autre caractéristique particulièrement avantageuse de l'invention, les signaux de données sont du type internet exclusivement.

Selon une autre caractéristique particulièrement avantageuse de l'invention, les signaux de données sont du type télévision exclusivement.

Selon une autre caractéristique particulièrement avantageuse de l'invention, les signaux de données incluent des signaux du type télécommunications.

Selon une autre caractéristique particulièrement avantageuse de l'invention, la station terrestre d'émission et de réception de signaux de données numériques de type internet et/ou télévision est reliée par liaison filaire ou sans fil numérique à un ou plusieurs fournisseurs d'accès internet ou de signaux de télévision.

En effet, les mouvements (trajectoires) des avions dans le ciel étant simplement coordonnés pour éviter les collisions, il existe lors de la mise en oeuvre du procédé de l'invention : un problème d'interférences liées :
- au recouvrement partiel ou total au sol des différents rayonnements reçus au sol et émis par les charges utiles des différents avions,
- aux interférences des émissions entre avions.

Les autres éléments constitutifs d'un dispositif susceptible de mettre en oeuvre le procédé de l'invention sont, selon un mode de réalisation non limitatif, les suivants :
- un ou plusieurs fournisseurs d'accès internet,
- une ou plusieurs stations terrestres d'émission et de réception de signaux du ou des fournisseurs d'accès internet avec les avions, connectées d'un côté à un ou plusieurs fournisseurs d'accès internet et de l'autre côté à une ou plusieurs antennes d'émission sol-air et de réception air-sol des signaux, lesquelles bases terrestres sont équipées d'un ou plusieurs dispositifs de poursuite des avions et lesquelles antennes d'émission ou de réception pouvant être de deux groupes : un groupe d'antennes connectées aux avions en vol et un autre groupe d'antennes en écoute et à la recherche de nouveaux avions à connecter,
- un ou plusieurs avions connectés d'une part, à une ou plusieurs stations terrestres, d'autre part, à des utilisateurs au sol équipés de moyens d'émission et de réception, lesquels avions pouvant être connectés entre eux afin d'étendre la zone de couverture ou de couvrir la surface terrestre toute entière,
- un ou plusieurs satellites (selon une autre caractéristique de l'invention) connectés d'un côté à une ou plusieurs stations terrestres d'interconnexion du ou des fournisseurs d'accès internet avec le ou les satellites, de l'autre côté avec un ou plusieurs avions, lesquels avions sont en retour connectés à des utilisateurs au sol équipés de moyens d'émission et de réception.
- plusieurs utilisateurs au sol équipés de moyens d'émission sol-air des signaux vers les avions et de réception air-sol des signaux en provenance des avions.

Selon une autre caractéristique du procédé de l'invention, une ou plusieurs stations terrestres sont connectées par liaison numérique sans fil à un ou plusieurs satellites lequel satellite est en retour connecté par liaison sans fil numérique à un ou plusieurs aéronefs, lesquels aéronefs sont en retour connectés par liaison sans fil numérique à des utilisateurs au sol équipés de moyens d'émission et de réception.

Selon une autre caractéristique du procédé de l'invention, les moyens d'émission sol-air des signaux vers les aéronefs et de réception air-sol des signaux en provenance des aéronefs équipant les utilisateurs au sol comprennent plusieurs antennes d'émission sol-air et de réception air-sol des signaux et sont équipées d'un ou plusieurs dispositifs de poursuite des aéronefs et lesquelles antennes d'émission ou de réception pouvant être de deux groupes : un groupe d'antennes connectées aux aéronefs en vol et un autre groupe d'antennes en écoute et à la recherche de nouveaux aéronefs à connecter.

Selon une autre caractéristique de l'invention, les utilisateurs au sol au lieu de se connecter directement aux avions, peuvent être connectés aux stations terrestres et/ou entre eux.

Les concepts fondamentaux de l'invention venant d'être exposés ci-dessus dans leur forme la plus élémentaire, d'autres détails et caractéristiques ressortiront plus clairement à la lecture de la description qui suit et en regard des dessins annexés, donnant à titre d'exemple non limitatif, plusieurs modes de réalisation d'un réseau obtenu selon le procédé conforme à l'invention.

### BRÈVE DESCRIPTION DES DESSINS

La figure 1 illustre un premier mode de réalisation conforme à l'invention d'un réseau de communication internet ;
La figure 2 illustre un deuxième mode de réalisation conforme à l'invention d'un réseau internet ;
La figure 3 illustre un troisième mode de réalisation conforme à l'invention d'un réseau internet ;
La figure 4 illustre un quatrième mode de réalisation conforme à l'invention d'un réseau internet ;
La figure 5 illustre un cinquième mode de réalisation conforme à l'invention d'un réseau internet ;
La figure 6 illustre le champ de rayonnement au sol d'une antenne située en altitude ;
La figure 7a est un dessin schématique d'une vue de face d'un mode de réalisation d'une antenne d'une charge utile conforme à l'invention avec son module de commande ;
La figure 7b est un dessin schématique d'une vue en section de l'antenne de la figure 7a.

### DESCRIPTION DES MODES PRÉFÉRÉS DE RÉALISATION

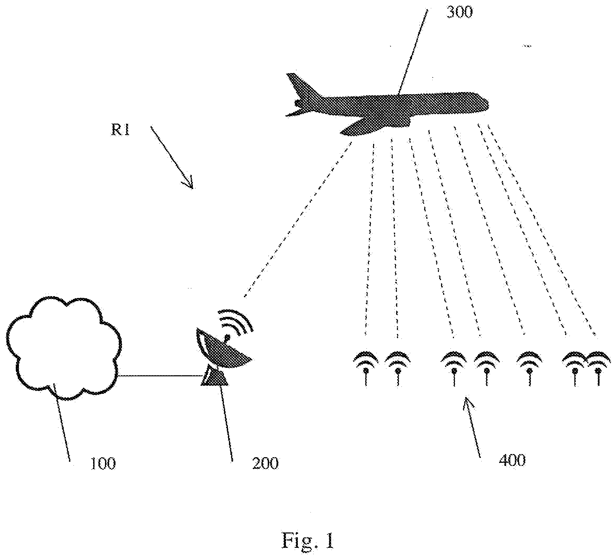

Comme illustré sur le dessin de la figure 1, le réseau R1 comprend un ou plusieurs fournisseurs d'accès internet 100. Ce ou ces plusieurs fournisseurs d'accès internet s'interconnectent à une ou plusieurs stations terrestres 200 d'émission et de réception de signaux internet.

Ces stations terrestres 200 communiquent avec une constellation d'avions 300 (un seul est illustré) de transport de passagers, avions équipés pour ce faire d'une charge utile d'émission et de réception de signaux internet. Ces avions peuvent transporter de deux à plus de six cents passagers.

Les stations sont équipées d'une pluralité d'antennes d'émission et de réception (sol-air/air-sol) des signaux internet. Elles sont équipées d'un dispositif de poursuite du ou des avions. Cette pluralité d'antennes est répartie en deux groupes :
- un groupe d'antennes connectées aux avions en vol, et
- un groupe d'antennes en écoute à la recherche de nouveaux avions à connecter.

Conformément à l'invention, la puissance d'émission des stations et des charges utiles des avions est modulée en fonction de l'altitude de ces derniers. Lesdites charges utiles transportées par les avions 300 comprennent des moyens d'amplification et de polarisation des signaux reçus.

En addition des stations 200, des utilisateurs au sol 400 équipés eux-mêmes de moyens d'émission et de réception communiquent avec ledit avion 300 et dispose ainsi du service internet.

Comme décrit plus haut, l'avion 300 dispose de tous les équipements permettant de protéger ses passagers et ses équipements des rayonnements avec :
- au moins une couche de peinture absorbante des rayonnements électromagnétiques issus des signaux reçus appliquée sur la paroi extérieure de l'avion,
- des matériaux d'isolation phonique et thermique absorbant les rayonnements électromagnétiques appliqués sur la paroi intérieure de l'avion,
- des panneaux d'habillage intérieur de l'avion constitués de matériaux absorbant des rayonnements électromagnétiques.
- des hublots constitués de matériaux absorbant les rayonnements électromagnétiques.

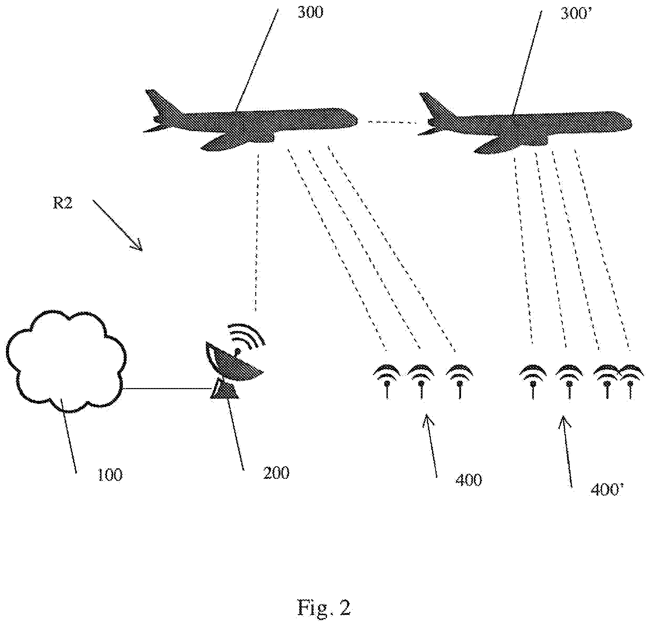

Le mode de réalisation du réseau R2 illustré par le dessin de la figure 2 montre la possibilité des avions 300 et 300' à se connecter entre eux afin d'étendre la zone de couverture et de couvrir ainsi la surface terrestre en totalité.

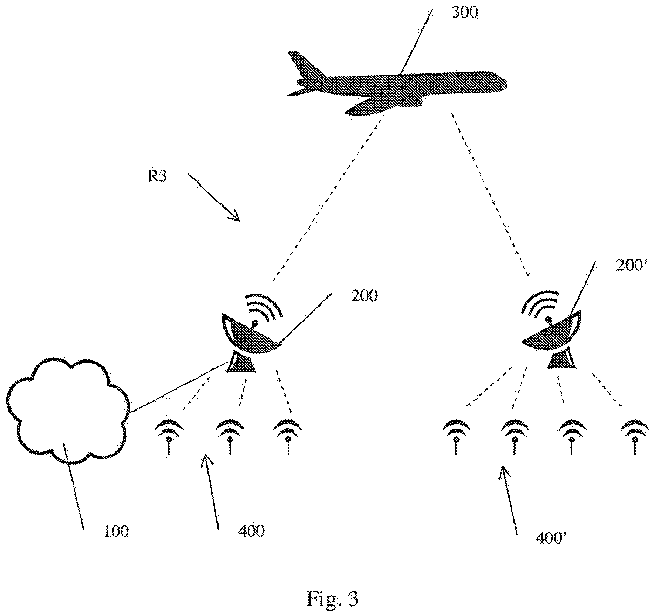

Le mode de réalisation du réseau R3 illustré par le dessin de la figure 3 montre que les utilisateurs 400 et 400' peuvent se connecter préalablement aux stations 200 et 200' communiquant toutes deux avec l'avion 300 pour disposer d'internet par un fournisseur d'accès 100 accessible par une seule station 200.

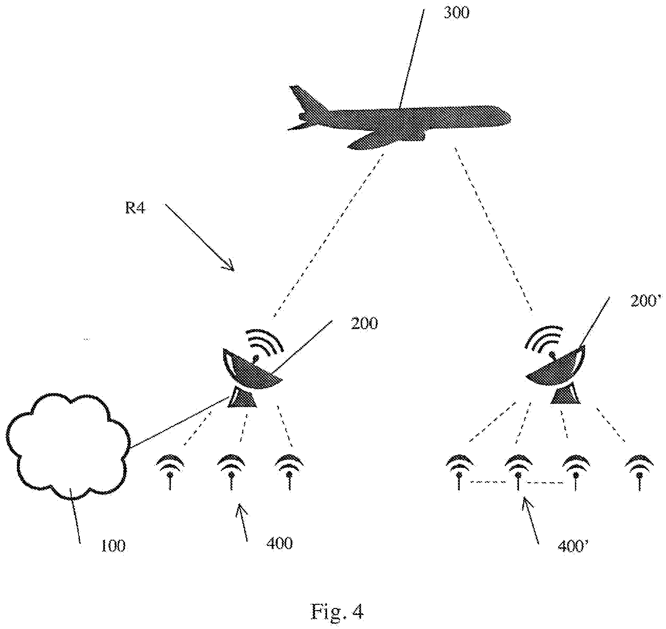

Le mode de réalisation du réseau R4 illustré par le dessin de la figure 4 montre que les utilisateurs 400' peuvent communiquer entre eux avant de se connecter à la station 200'.

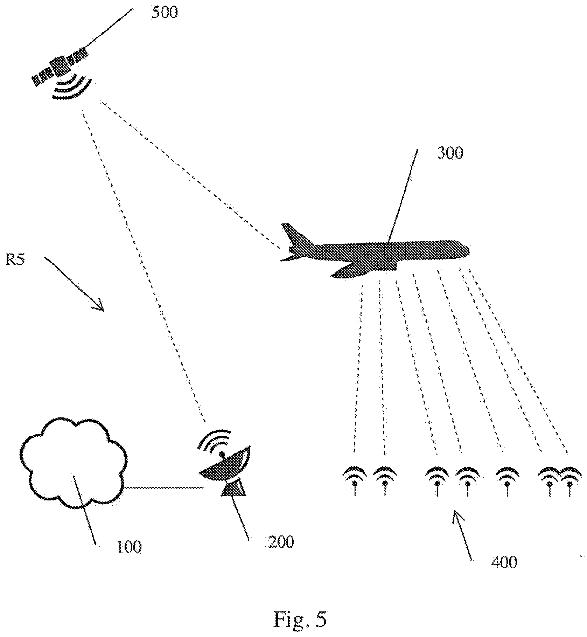

Le mode de réalisation du réseau R5 illustré par le dessin de la figure 5, intègre la présence d'au moins un satellite 500 connecté à au moins une station 200 et à au moins un avion 300 les avions sont en retour connectés à des utilisateurs 400 au sol.

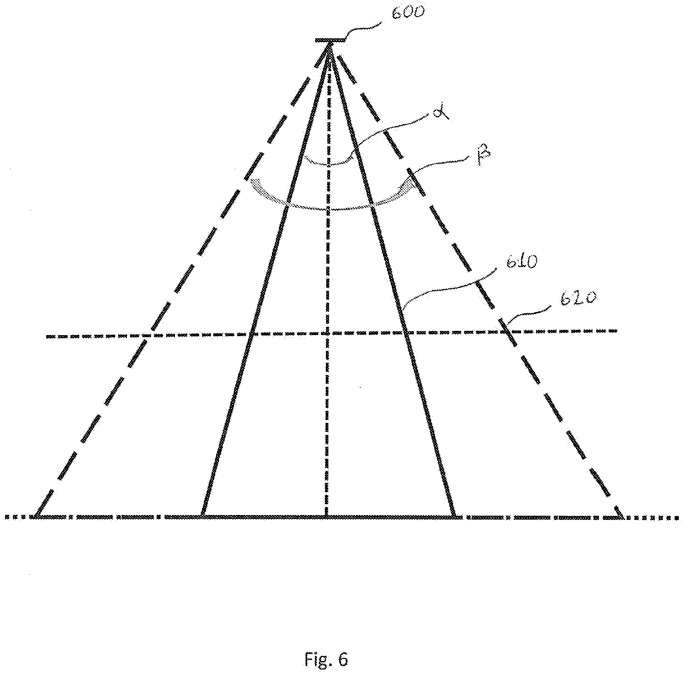

Comme illustrée sur le dessin de la figure 6, l'antenne 600 a un grand angle d'ouverture. On décompose le champ de rayonnement des signaux émis par l'antenne 600 en deux secteurs angulaires présentant des variations dans la puissance du rayonnement reçu au sol. Le premier secteur angulaire 610 dessiné en trait continu défini par l'angle alpha concerne un secteur où la puissance du rayonnement reçu au sol est la plus forte. Un deuxième secteur angulaire 620 plus grand que le premier dessiné en traits interrompus et défini par l'angle bêta concerne au delà de l'angle alpha, une portion de secteur périphérique où la puissance du rayonnement reçu au sol est moins forte et peu exploitable. Ainsi, il est connu que la puissance du rayonnement reçu au sol diminue au fur et à mesure que l'on s'éloigne du centre du secteur angulaire de diffusion.

On comprend en outre que la surface concernée par ce rayonnement augmente ou diminue au fur et à mesure que l'antenne s'éloigne du sol ou s'en rapproche.

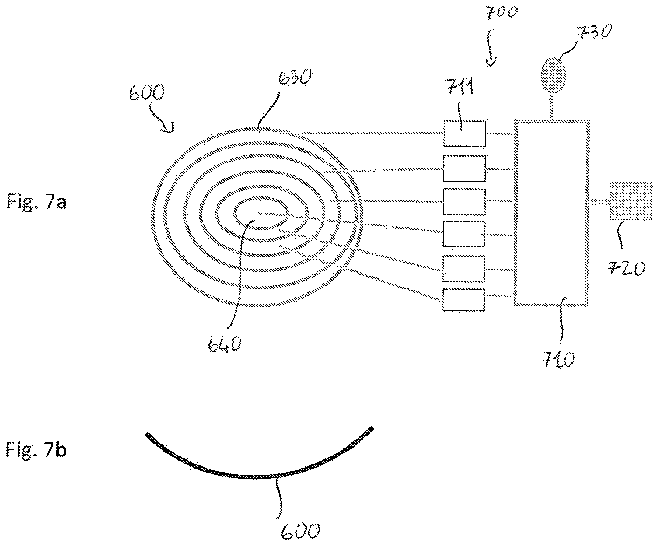

Comme illustrée sur le dessin de la figure 7a, pour pallier cet inconvénient d'une puissance de rayonnement reçu au sol non homogène, l'antenne 600 présente une architecture particulière et est associée à un module de commande 700.

Ce module de commande 700 comporte un variateur ou adaptateur 710 de la puissance de l'alimentation générale 720 de l'antenne pouvant aller de zéro pour cent lorsque l'avion est au sol à cent pour cent lorsque l'avion a atteint son altitude maximale. Pour ce faire, le variateur 710 est relié à un récepteur de données de mesure d'altitude 730.

Ainsi, chaque point de la surface rayonnée au sol par l'antenne 600 reçoit la même puissance rayonnée quelle que soit l'altitude de l'aéronef. De plus, le rayonnement de l'antenne 600 est arrêté une fois l'avion au sol.

En outre, l'antenne 600 est composée de plusieurs cellules concentriques 630 munies chacune d'un variateur 711 individuel de puissance permettant d'adapter la puissance d'alimentation de chaque cellule en fonction de la position de chaque cellule par rapport à la cellule centrale 640 de telle façon que la valeur de la puissance d'alimentation individuelle de chaque cellule augmente de la cellule centrale vers les cellules périphériques de manière à avoir la même puissance rayonnée reçue au sol quelle que soit la position du point de réception des signaux numériques dans la surface rayonnée au sol.

Ainsi, grâce à l'antenne de l'invention, la puissance de rayonnement reçu est sensiblement la même que ce soit dans le cône de diffusion central 610 ou celui plus périphérique 620.

On comprend que le réseau obtenu, la charge utile et l'avion, qui viennent d'être ci-dessus décrits et représentés, l'ont été en vue d'une divulgation plutôt que d'une limitation. Bien entendu, divers aménagements, modifications et améliorations pourront être apportés à l'exemple ci-dessus, sans pour autant sortir du cadre des revendications.

## Revendications

1. Charge utile utilisée dans un système de fourniture de signaux de données numériques de type internet et/ou télévision sur toute la surface du globe terrestre,
laquelle surface accueille
au moins une station terrestre (200) d'émission et de réception de signaux de données numériques de type internet et/ou télévision,
le système reliant par liaison sans fil numérique au moins un aéronef (300) avec la station terrestre (200) d'émission et de réception de signaux numériques de données de type internet et/ou télévision d'une part et d'autre part avec au moins un moyen d'émission et de réception de signaux de données de type internet et/ou télévision individuels ou collectifs fixe ou porté par au moins un utilisateur (400),
ledit aéronef étant adapté pour évoluer à une altitude inférieure ou égale à dix kilomètres au-dessus de la surface du globe terrestre, et
étant équipé d'une ou plusieurs charges utiles de telle façon à servir de relais d'émission et de réception pour la fourniture d'au moins un type desdits signaux sur la surface du globe terrestre,
**CARACTÉRISÉE PAR LE FAIT QUE** la charge utile comprend une antenne d'émission des signaux de données numériques vers la surface du globe terrestre et un module de commande (700), l'antenne étant associée au module de commande, la puissance des signaux, rayonnements, émis par la charge utile étant modulée pour varier en fonction de l'altitude de l'aéronef (300) et peut donc varier de 0% au sol à 100% en vol de croisière, où le module de commande (700) comporte un variateur (710) de puissance de l'alimentation générale de l'antenne (600) de zéro pour cent, lorsque l'aéronef est au sol, à cent pour cent, lorsque l'aéronef a atteint son altitude maximale, le variateur (710) étant relié à un récepteur de données de mesure d'altitude, et où l'antenne (600) a un angle d'ouverture et est composée de plusieurs cellules concentriques (630) munies chacune d'un variateur individuel (711) de puissance permettant d'adapter la puissance d'alimentation de chaque cellule (630) en fonction de la position de chaque cellule par rapport à la cellule centrale (640) de telle façon que la valeur de la puissance d'alimentation individuelle de chaque cellule (630) augmente de la cellule centrale (640) vers les cellules périphériques de telle façon que chaque point de la surface rayonnée au sol par l'antenne reçoive la même puissance rayonnée quelle que soit l'altitude de l'aéronef et de telle façon à pouvoir éteindre le rayonnement de l'antenne une fois l'aéronef au sol.

2. Charge utile selon la revendication 1, où l'antenne a un grand angle d'ouverture qui atteint 180 degrés lui permettant de couvrir une très grande surface rayonnée au sol pouvant atteindre sept cent mille kilomètres carrés.

3. Charge utile selon la revendication 1 ou 2, où l'angle d'ouverture est variable en fonction de l'altitude grâce à un moyen de variation d'angle d'ouverture dont l'antenne est munie.

4. Charge utile selon la revendication 3, où le moyen de variation d'angle d'ouverture est relié à des capteurs de mesure d'altitude équipant l'aéronef et/ou la charge utile.

5. Charge utile selon la revendication 3, où la variation d'angle d'ouverture se fait dans le sens croissant lorsque l'altitude décroit de telle façon à permettre à l'antenne d'avoir la même surface rayonnée au sol quelle que soit l'altitude à laquelle se trouve l'aéronef.

6. Charge utile selon la revendication 1, où l'angle d'ouverture maximal atteint 180 degrés.

7. Charge utile selon la revendication 1, où la valeur maximale de l'angle d'ouverture est comprise entre 90 degrés et 180 degrés.

8. Charge utile selon revendication 1, où la puissance maximale d'alimentation de la charge utile atteint 500 Kilowatts.

9. Charge utile selon revendication 1, où la puissance maximale d'alimentation de la charge utile est comprise entre 2 Kilowatts et 500 Kilowatts.

10. Charge utile selon revendication 1, où la puissance maximale d'alimentation de la charge utile est comprise entre 23 Kilowatts et 500 Kilowatts.

11. Charge utile selon revendication 1, où la puissance maximale d'alimentation de la charge utile est comprise entre 30 Kilowatts et 500 Kilowatts.

12. Système de fourniture de signaux de données numériques de type internet et/ou télévision sur toute la surface du globe terrestre, où le système comprend la charge utile selon l'une quelconque des revendications 1 à 11.

13. Avion (300) de transport de passagers et/ou de fret, ledit avion (300) étant équipé d'au moins une charge utile selon l'une quelconque des revendications 1 à 11.

## Patentansprüche

1. Nutzlast, die in einem System zum Bereitstellen von Signalen digitaler Daten vom Typ Internet und/oder Fernsehen auf der gesamten Oberfläche der Erdkugel verwendet wird,
wobei sich auf der Oberfläche Folgendes befindet
mindestens eine Bodenstation (200) zum Aussenden und Empfangen von Signalen digitaler Daten vom Typ Internet und/oder Fernsehen,
wobei das System mindestens ein Luftfahrzeug (300) mittels drahtloser digitaler Verbindung einerseits mit der Bodenstation (200) zum Aussenden und Empfangen von Signalen digitaler Daten vom Typ Internet und/oder Fernsehen und andererseits mit mindestens einem Mittel zum Aussenden und Empfangen von individuellen oder gemeinschaftlichen Signalen digitaler Daten vom Typ Internet und/oder Fernsehen verbindet, welches fest angeordnet ist oder von mindestens einem Anwender (400) getragen wird,
wobei das Luftfahrzeug dafür geeignet ist, sich in einer Höhe von höchstens zehn Kilometern oberhalb der Oberfläche der Erdkugel aufzuhalten, und
wobei es derart mit einer oder mehreren Nutzlasten versehen ist, dass es als Sende- und Empfangsrelais zum Bereitstellen mindestens einer Art dieser Signale auf der Oberfläche der Erdkugel dient,
**DADURCH GEKENNZEICHNET, DASS** die Nutzlast eine Antenne zum Aussenden der Signale digitaler Daten in Richtung der Oberfläche der Erdkugel und ein Steuermodul (700) umfasst, wobei die Antenne mit dem Steuermodul in Verbindung steht, wobei die Leistung der Signale, der Strahlungen, welche von der Nutzlast ausgesendet werden, derart moduliert wird, dass sie in Abhängigkeit von der Höhe des Luftfahrzeugs (300) variiert und somit zwischen 0 % am Boden und 100 % in der Dienstflughöhe variieren kann, wobei das Steuermodul (700) einen Leistungsregler (710) für die allgemeine Stromversorgung der Antenne (600) von null Prozent, wenn sich das Luftfahrzeug am Boden befindet, bis einhundert Prozent umfasst, wenn das Luftfahrzeug seine maximale Höhe erreicht hat, wobei der Regler (710) mit einem Höhenmessungsdatenempfänger verbindet ist, und wobei die Antenne (600) einen Öffnungswinkel aufweist und sich aus mehreren konzentrischen Zellen (630) zusammensetzt, welche jeweils mit einem einzelnen Leistungsregler (711) versehen sind, der es ermöglicht, die Stromversorgungsleistung jeder der Zellen (630) in Abhängigkeit von der Position gegenüber der mittleren Zelle (640) derart anzupassen, dass der Wert der individuellen Stromversorgungsleistung jeder der Zellen (630) von der mittleren Zelle (640) zu den randständigen Zellen hin derart zunimmt, dass jeder Punkt der Oberfläche, welche am Boden von der Antenne bestrahlt wird, unabhängig von der Höhe des Luftfahrzeugs dieselbe Strahlungsleistung erhält und dass die Strahlung der Antenne abgestellt werden kann, sobald sich das Luftfahrzeug am Boden befindet.

2. Nutzlast nach Anspruch 1, wobei die Antenne einen großen Öffnungswinkel hat, der 180 Grad erreicht, wodurch sie dazu befähigt ist, eine sehr große Bestrahlungsfläche am Boden abzudecken, die siebenhunderttausend Quadratkilometer erreichen kann.

3. Nutzlast nach den Ansprüchen 1 oder 2, wobei die Variabilität des Öffnungswinkels in Abhängigkeit von der Höhe durch ein Mittel zur Öffnungswinkelvariation ermöglicht wird, mit welchem die Antenne versehen ist.

4. Nutzlast nach Anspruch 3, wobei das Mittel zur Öffnungswinkelvariation mit Höhenmessungssensoren verbunden ist, mit welchen das Luftfahrzeug und/oder die Nutzlast ausgestattet ist/sind.

5. Nutzlast nach Anspruch 3, wobei die Öffnungswinkelvariation im Sinne einer Zunahme erfolgt, wenn die Höhe abnimmt, sodass die Antenne unabhängig von der Höhe, in welcher sich das Luftfahrzeug befindet, die gleiche Fläche am Boden bestrahlen kann.

6. Nutzlast nach Anspruch 1, wobei der maximale Öffnungswinkel 180 Grad erreicht.

7. Nutzlast nach Anspruch 1, wobei der Höchstwert des Öffnungswinkels im Bereich von 90 Grad bis 180 Grad liegt.

8. Nutzlast nach Anspruch 1, wobei die maximale Stromversorgungsleistung der Nutzlast Kilowatt erreicht.

9. Nutzlast nach Anspruch 1, wobei die maximale Stromversorgungsleistung der Nutzlast im Bereich von 2 Kilowatt bis 500 Kilowatt liegt.

10. Nutzlast nach Anspruch 1, wobei die maximale Stromversorgungsleistung der Nutzlast im Bereich von 23 Kilowatt bis 500 Kilowatt liegt.

11. Nutzlast nach Anspruch 1, wobei die maximale Stromversorgungsleistung der Nutzlast 500 im Bereich von 30 Kilowatt bis 500 Kilowatt liegt.

12. System zum Bereitstellen von Signalen digitaler Daten vom Typ Internet und/oder Fernsehen auf der gesamten Oberfläche der Erdkugel, wobei das System die Nutzlast nach einem beliebigen der Ansprüche 1 bis 11 umfasst.

13. Flugzeug (300) zum Transport von Passagieren und/oder Fracht, wobei das Flugzeug (300) mit mindestens einer Nutzlast nach einem beliebigen der Ansprüche 1 bis 11 ausgestattet ist.

## Claims

1. Payload used in a system for the provision of internet and/or television type digital data signals across the complete land surface,
said surface receives
At least one earth station (200) for emission and receipt of internet and/or television type digital data signals,
the system linking, through a digital wireless link at least one aircraft (300) with the earth station (200) for emission and receipt of internet and/or television type digital data signals on one hand and on the other hand with at least one emission and receipt means for data signals of internet and/or television type that are individual or collective, fixed or borne by at least one user (400),
The said aircraft being adapted to move to an altitude less than or equal to ten kilometers above the global land surface, and
being equipped with one or several payloads in such a way as to use emission and receipt relays for the provision of at least one type of signal on the global land surface.
**CHARACTERIZED BY** THE FACT THAT the payload comprises a digital data signal emission antenna to the global land surface and a command module (700), the antenna being associated with the command module,
the power of signals, radiations, emitted by the payload being modulated to vary according to the altitude of the aircraft (300) and can vary from 0% on the ground to 100% during cruising,
where command module (700) includes a power adapter (710) for the general supply for the antenna (600) from zero percent when the aircraft is on the ground to hundred percent when the aircraft has attained its maximum altitude, and where
the antenna (600) has an opening angle and comprises several concentric cells (630), each one equipped with an individual power unit (711) that enables customizing the power supply of each cell based on the position of each cell (630) with respect to the central cell (640), such that the value of the individual power supply of each cell (630) increases from the central cell (640) to the peripheral cells
so as each point of the radiated ground receives the same radiation power irrespective of the aircraft altitude and such that to be able to turn off the antenna once the aircraft is on the ground.

2. Payload according to claim 1, in which the antenna has a large opening angle that attains 180 degrees that enables it to cover a very large surface with radiation on the ground that can attain seven hundred thousand square kilometers.

3. Payload according to claim 1 or 2, in which the angle of opening is variable based on the altitude thanks to a means for opening angle variation that the antenna is equipped with.

4. Payload according to claim 3, in which the opening angle variation means is linked to altitude measurement sensors that are provided in the aircraft and/or payload.

5. Payload according to claim 3, in which the variation in the opening angle occurs in an upward direction when the altitude decreases so as to enable the antenna to have the same radiated surface on the ground, irrespective of the aircraft altitude.

6. Payload according to claim 1, in which the maximum opening angle reaches 180 degrees.

7. Payload according to claim 1, in which the maximum value of the opening angle is between 90 and 180 degrees

8. Payload according to claim 1, in which the maximum power supply of the payload reaches 500 Kilowatts.

9. Payload according to claim 1, in which the maximum power supply of the payload is between 2 and 500 Kilowatts.

10. Payload according to claim 1, in which the maximum power supply of the payload is between 23 and 500 Kilowatts.

11. Payload according to claim 1, in which the maximum power supply of the payload is between 30 and 500 Kilowatts.

12. System for the provision of internet and/or television type digital data signals across the complete land surface, in which the system comprises the payload according any one of the claims 1 to 11.

13. Passenger and/or freight transport aircraft (300), said aircraft (300) being equipped with at least one payload according any one of the claims 1 to 11.
